# EUROPÄISCHE PATENTANMELDUNG

(11) **EP 4 017 229 A1**
(43) Veröffentlichungstag der Anmeldung: **22.06.2022**
(21) Anmeldenummer: 20214263.4
(22) Anmeldetag: 15.12.2020
(51) Int. Cl.: H05K 7/14, H05K 7/20

(54) **VORRICHTUNG ZUR EINFASSUNG EINER LEISTUNGSEINHEIT UND ZUR ZENTRIERUNG EINER ANSTEUERUNGSEINHEIT BEZÜGLICH DER LEISTUNGSEINHEIT**

(71) Anmelder: Siemens Aktiengesellschaft, 80333 München (DE)
(72) Erfinder: Kögler, Roman, 90403 Nürnberg (DE); Roppelt, Bernd, 96173 Unterhaid (DE); Schmenger, Jens, 91301 Forchheim (DE); Schwinn, Thomas, 91074 Herzogenaurach (DE)

(57) **Zusammenfassung**

Die Erfindung betrifft eine Vorrichtung (1) zur Einfassung einer wenigstens teilweise innerhalb und/oder auf einem Kühlkörper (8) ausgebildeten Leistungseinheit (11) und zur Zentrierung einer Ansteuerungseinheit (20) bezüglich der Leistungseinheit (11), wobei die Leistungseinheit (11) wenigstens ein Halbleiterbauelement (6) und ein Substrat (7) umfasst, aufweisend: einen Rahmen (2), wobei der Rahmen (2) das Substrat (7) wenigstens teilweise, vorzugsweise vollständig, umgibt; wenigstens ein vorstehendes Stück erster Art (3), wobei das vorstehende Stück erster Art (3) zum Eingriff in eine Vertiefung oder eine Öffnung (12) eines Kühlkörpers (8) ausgebildet ist; wenigstens ein vorstehendes Stück zweiter Art (4), wobei das vorstehende Stück zweiter Art (4) zum Eingriff in eine Vertiefung oder eine Öffnung (21) einer wenigstens ein elektronisches Bauelement (24) aufweisenden Ansteuerungseinheit (20) ausgebildet ist.

## Beschreibung

Die Erfindung betrifft eine Vorrichtung zur Einfassung einer wenigstens teilweise innerhalb und/oder auf einem Kühlkörper ausgebildeten Leistungseinheit und zur Zentrierung einer Ansteuerungseinheit bezüglich der Leistungseinheit.

Eine aus dem Stand der Technik bekannte Leistungseinheit weist ein Gehäuse auf, welches mit einem Kühlkörper verschraubt ist. Hierfür ist eine Bohrung mit einem Gewinde im Kühlkörper nötig. Dies verschlechtert jedoch eine Kühlung der Leistungseinheit, da insbesondere eine gewünschte Anzahl an Kühlrippen, nicht möglich ist. Zudem kann auch ein Abstand der Kühlrippen zueinander, welcher eine optimale Durchströmung von z. B. Luft gewährleistet, nicht immer eingehalten werden.

Der Erfindung liegt die Aufgabe zugrunde, dies zu verbessern.

Die Lösung der Aufgabe geling durch Anspruch 1, d. h. eine Vorrichtung zur Einfassung einer wenigstens teilweise innerhalb und/oder auf einem Kühlkörper ausgebildeten Leistungseinheit und zur Zentrierung einer Ansteuerungseinheit bezüglich der Leistungseinheit, wobei die Leistungseinheit wenigstens ein Halbleiterbauelement und ein Substrat umfasst, aufweisend:
- einen Rahmen, wobei der Rahmen das Substrat wenigstens teilweise, vorzugsweise vollständig, umgibt,
- wenigstens ein vorstehendes Stück erster Art, wobei das vorstehende Stück erster Art zum Eingriff in eine Vertiefung oder eine Öffnung eines Kühlkörpers ausgebildet ist,
- wenigstens ein vorstehendes Stück zweiter Art, wobei das vorstehende Stück zweiter Art zum Eingriff in eine Vertiefung oder eine Öffnung einer wenigstens ein elektronisches Bauelement aufweisenden Ansteuerungseinheit ausgebildet ist.

Die Vorrichtung ist vorzugsweise einteilig.

Das Substrat fungiert vorteilhaft als Leitelement.

Das Substrat umfasst z. B. wenigstens eine elektrisch leitfähige Schicht, wobei die elektrisch leitfähige Schicht vorzugsweise Kupfer aufweist, und wenigstens eine thermisch leitfähige Schicht, wobei die thermisch leitfähige Schicht vorzugsweise Keramik aufweist.

Die thermisch leitfähige Schicht ist vorteilhaft elektrisch isolierend. Diese soll einerseits eine Isolation herstellen sowie andererseits Abwärme abführen. Keramik ist hierbei von Vorteil, da dadurch die Herstellung der elektrischen Isolation besonders gut gelingt.

Besonders vorteilhaft weist das Substrat drei Schichten auf. Eine erste Schicht, welche dem Kühlkörper zugewandt ist, weist vorzugsweise Kupfer auf. Eine zweite Schicht, die an die erste Schicht angrenzt, weist vorzugsweise Keramik auf. Eine dritte Schicht, die an die zweite Schicht angrenzt, weist vorzugsweise Kupfer auf. Die erste und die dritte Schicht sind somit elektrisch leitfähige Schichten, die zweite Schicht ist somit eine thermisch leitfähige Schicht. Die thermisch leitfähige Schicht ist vorteilhaft elektrisch isolierend.

Das Leitelement umfasst vorzugsweise an und/oder auf der dritten Schicht wenigstens ein Halbleiterbauelement, vorzugsweise eine Mehrzahl an Halbleiterbauelementen.

Die Leistungseinheit ist vorzugsweise Teil eines Umrichtersystems bzw. Stromrichtersystems.

Die Vorrichtung ersetzt das bisherige Gehäuse und ist hierbei konstruktiv stark vereinfacht. Zudem ist durch die Erfindung auch eine Baugrößenreduzierung bei ausreichender und gleichmäßiger Kühlung möglich.

Die Leistungseinheit kann wenigstens teilweise innerhalb und/oder auf einem Kühlkörper ausgebildet sein.

Bevorzugt ist die Leistungseinheit auf einer Oberfläche des Kühlkörpers ausgebildet.

Jedoch besteht die Möglichkeit, dass der Kühlkörper eine Einkerbung bzw. Vertiefung aufweist, in welcher die Leistungseinheit vollständig oder nur teilweise ausgebildet ist.

Vorteilhaft ist eine Ausführungsform, wonach die Vorrichtung zwei vorstehende Stücke erster Art aufweist.

Dies wird in der Figurenbeschreibung näher erläutert.

Die Vorrichtung ist dadurch derart ausgestaltet, dass sie sicher auf dem Kühlkörper platziert werden kann, da durch die vorstehenden Stücke erster Art ein Verdrehen verhindert wird.

Vorteilhaft ist eine Ausführungsform, wonach die Vorrichtung ein Fixierungselement zur Fixierung der Ansteuerungseinheit aufweist.

Das Fixierungselement ist vorteilhaft eine Vorrichtung, die zu einer kraftschlüssigen Verbindung und/oder formschlüssigen Verbindung mit einem weiteren Körper ausgebildet ist.

Das Fixierungselement ist beispielsweise eine Vorrichtung mit einem Innengewinde, die zur Aufnahme eines Körpers mit einem Außengewinde, z. B. eine Schraube, ausgebildet ist.

Eine Lösbarkeit ist durch eine Schraube gewährleistet. Daher wird diese Ausführungsform bevorzugt.

Das Fixierungselement wird in der Figurenbeschreibung näher beschrieben.

Vorteilhaft ist eine Ausführungsform, wonach der Rahmen rechteckig ausgebildet ist.

Es sind jedoch auch andere Formen des Rahmens denkbar.

Vorteilhaft ist eine Ausführungsform, wonach das vorstehende Stück erster Art wenigstens im Wesentlichen an einer Ecke, insbesondere Außenecke, des Rahmens angeordnet ist.

Vorteilhaft ist eine Ausführungsform, wonach das vorstehende Stück zweiter Art wenigstens im Wesentlichen an einer Ecke, insbesondere Außenecke, des Rahmens angeordnet ist.

Vorteilhaft ist eine Ausführungsform, wonach wenigstens ein vorstehendes Stück erster Art und das vorstehende Stück zweiter Art miteinander verbunden und in gegensätzliche Richtungen ragend ausgebildet sind.

Vorteilhaft ist eine Ausführungsform, wonach wenigstens ein vorstehendes Stück erster Art und das Fixierungselement miteinander verbunden und in gegensätzliche Richtungen ragend ausgebildet sind.

Die beschriebenen Ausführungsformen werden in der Figurenbeschreibung näher erläutert.

Vorteilhaft ist eine Ausführungsform, wonach der Rahmen Polyphenylensulfid (kurz: PPS) aufweist.

PPS ist von Vorteil, da dies ein hochtemperaturbeständiger thermoplastischer Kunststoff ist.

Vorteilhaft ist beispielsweise eine Ausführungsform, wonach der Rahmen Polyphenylensulfid mit einem Faseranteil von 50 % bis 75 %, insbesondere 60 % bis 65 %, aufweist.

Jedoch können auch andere Kunststoffe eingesetzt werden.

Die Lösung der oben gestellten Aufgabe gelingt ferner durch Anspruch 10, d. h. ein Leistungsmodul, aufweisend:
- wenigstens einen Kühlkörper,
- wenigstens eine Leistungseinheit, wobei die Leistungseinheit wenigstens ein Halbleiterbauelement und ein Substrat umfasst,
- eine beschriebene Vorrichtung, wobei die Vorrichtung umfasst:
- einen Rahmen, wobei der Rahmen das Substrat wenigstens teilweise, vorzugsweise vollständig, umgibt,
- wenigstens ein vorstehendes Stück erster Art, wobei das vorstehende Stück erster Art zum Eingriff in eine Vertiefung oder eine Öffnung des Kühlkörpers ausgebildet ist,
- wenigstens ein vorstehendes Stück zweiter Art, wobei das vorstehende Stück zweiter Art zum Eingriff in eine Vertiefung oder eine Öffnung einer wenigstens ein elektronisches Bauelement aufweisenden Ansteuerungseinheit ausgebildet ist.

Vorteilhaft ist eine Ausführungsform, wonach der Rahmen derart ausgebildet ist, dass eine aufgebrachte Vergussmasse innerhalb eines Bereichs, der vom Rahmen und dem Leistungsmodul eingegrenzt ist, verbleibt.

Die Vergussmasse ist vorteilhaft ein Isolationsmaterial, insbesondere Silikongel. Zudem sind Polyurethan und/oder Epoxide geeignet. Auch andere Arten sind denkbar.

Die Vergussmasse wird vorteilhaft als Verguss innerhalb des Rahmens aufgebracht und anschließend ausgehärtet.

Vorteilhaft ist die Leistungseinheit wenigstens teilweise, vorzugsweise vollständig von der Vergussmasse bedeckt. Auch Ausführungen, bei welchen die Leistungseinheit von Vergussmasse umgeben ist, sind denkbar.

Dies ist von Vorteil, da das Halbleiterbauelement somit an seinen Nennspannungen betrieben werden kann.

Vorteilhaft ist eine Ausführungsform, wonach der Rahmen mit einer Oberfläche des Leistungsmoduls stoffschlüssig, insbesondere mittels Klebung, verbunden ist.

Dies gewährleistet einen sicheren Halt. Eine stoffschlüssige Verbindung ist von Vorteil, da dadurch im Kühlkörper keine Befestigungsvorrichtungen vorgesehen werden müssen. Der Kühlkörper kann so ausgelegt und ausgebildet sein, dass eine Kühlung, insbesondere in Bezug auf seinen Kühlrippenabstand, optimal ist.

Es sind jedoch auch andere Verbindungen möglich.

Die Lösung der oben gestellten Aufgabe gelingt zudem durch Anspruch 13, d. h. einen Stromrichter, aufweisend:
- ein Leistungsmodul,
- eine wenigstens ein elektronisches Bauelement aufweisende Ansteuerungseinheit,
wobei das Leistungsmodul und die Ansteuerungseinheit miteinander verbunden sind.

Vorteilhaft ist eine Ausführungsform, wonach die Ansteuerungseinheit bezüglich des Leistungsmoduls durch einen Eingriff des vorstehenden Stücks zweiter Art des Leistungsmoduls in eine Vertiefung oder eine Öffnung der Ansteuerungseinheit zentriert ist.

Vorteilhaft ist eine Ausführungsform, wonach das Leistungsmodul und die Ansteuerungseinheit mittels des Fixierungselements verbunden sind.

Dies wird in der Figurenbeschreibung näher erläutert.

Im Folgenden wird die Erfindung anhand der in Figuren dargestellten Ausführungsbeispiele näher beschrieben und erläutert. Es zeigen:
- FIG 1: eine mögliche Ausgestaltung eines Leistungsmoduls,
- FIG 2: die mögliche Ausgestaltung aus FIG 1 in einer explodierten Ansicht,
- FIG 3 und FIG 4: ein Leistungsmodul, welches mit einer Ansteuerungseinheit verbunden ist,
- FIG 5: einen Stromrichter.

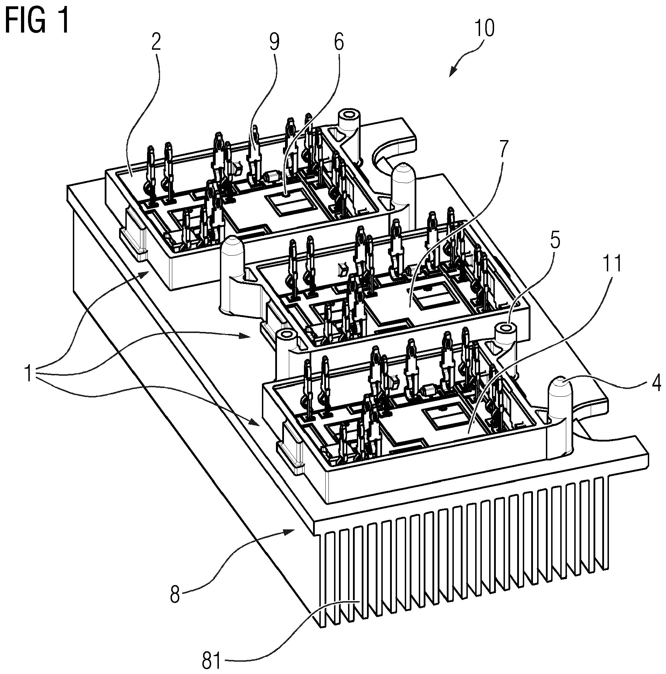

FIG 1 zeigt eine mögliche Ausgestaltung eines Leistungsmoduls 10, aufweisend eine Vorrichtung 1.

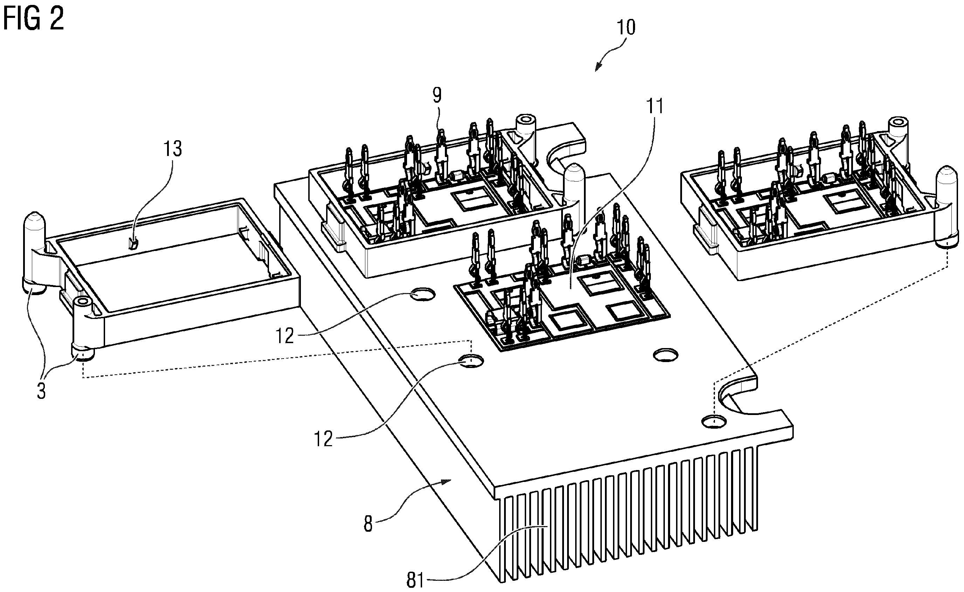

FIG 2 zeigt die mögliche Ausgestaltung aus FIG 1 in einer explodierten Ansicht.

Die Vorrichtung 1 fasst ein auf dem Leistungsmodul 10 ausgebildeten Leistungseinheit 11 ein.

Die Leistungseinheit 11 umfasst wenigstens ein Halbleiterbauelement 6. Dies ist insbesondere ein Leistungshalbleiter, z. B. IGBT. Die Leistungseinheit 11 umfasst ferner ein Substrat 7.

Die Vorrichtung 1 umfasst einen Rahmen 2, wobei der Rahmen 2 das Substrat 7 vollständig umgibt.

Die Vorrichtung 1 umfasst ferner zwei vorstehende Stücke erster Art 3 (in FIG 2 ersichtlich), wobei ein erstes vorstehendes Stück 3 zum Eingriff in eine Einkerbung bzw. Vertiefung 12, z. B. ein Sackloch, oder eine Öffnung eines Kühlkörpers 8 des Leistungsmoduls 10 ausgebildet ist.

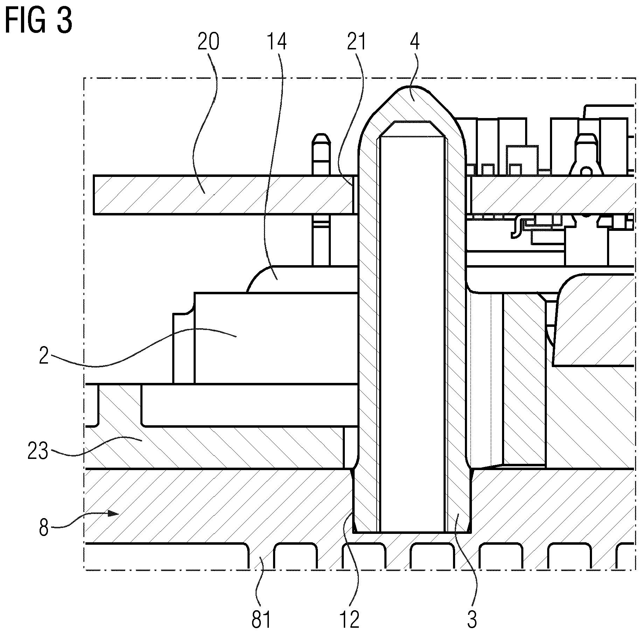

Die Vorrichtung 1 umfasst zudem wenigstens ein vorstehendes Stück zweiter Art 4, wobei das vorstehende Stück zweiter Art 4 zum Eingriff in eine Einkerbung bzw. Vertiefung oder eine Öffnung 21 (siehe FIG 3), z. B. ein Loch, einer wenigstens ein elektronisches Bauelement aufweisende Ansteuerungseinheit 20 (siehe FIG 3) ausgebildet ist.

Die Ansteuerungseinheit 20 ist vorteilhaft eine Hauptplatine.

Die Figur zeigt zudem Kontaktierungselemente 9. Ein Kontaktierungselement ist vorzugsweise ein Pin. Vorteilhaft weist die Leistungseinheit 11 eine Mehrzahl an Kontaktierungselementen 9 auf. Die Kontaktierungselemente 9 können als Einzelpins ausgeführt sein oder als mehrteiliges Pinsystem.

Der Kühlkörper 8 weist eine Mehrzahl an Kühlrippen 81 auf. Die Kühlrippen 81 sind vorteilhaft parallel angeordnet.

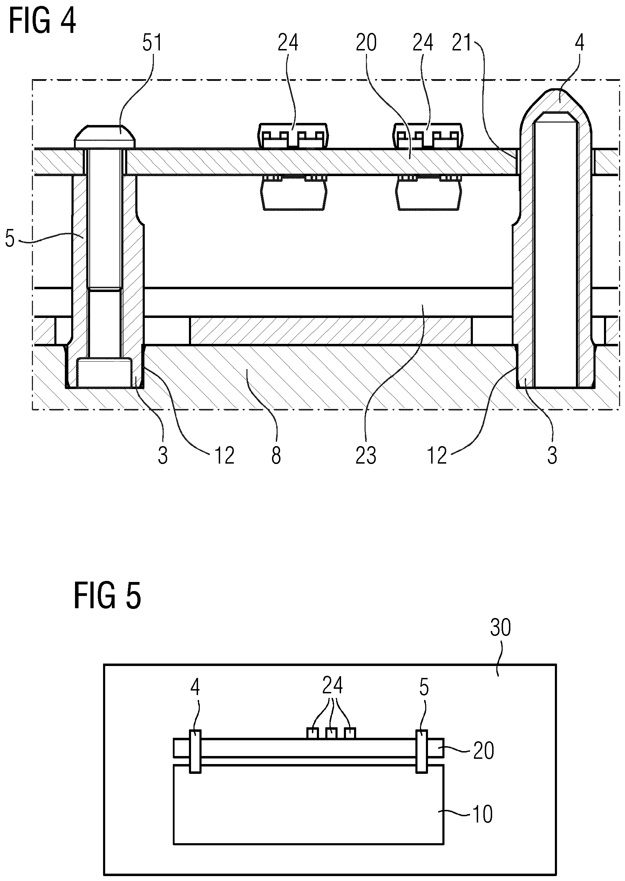

Die Vorrichtung 1 weist in der Figur ein Fixierungselement 5 auf. Das Fixierungselement 5 ist zur Fixierung der Ansteuerungseinheit 20 ausgebildet. Dies wird in FIG 4 näher beschrieben.

Der Rahmen 2 ist in der Figur rechteckig ausgebildet. Jedoch sind auch andere Formen denkbar, wie beispielsweise ein runder Rahmen, ein ovaler Rahmen, ein quadratischer Rahmen oder ein trapezförmiger Rahmen.

FIG 1 und FIG 2 zeigen, dass das vorstehende Stück erster Art 3 wenigstens im Wesentlichen an einer Außenecke bzw. im Bereich der Außenecke des Rahmens 2 angeordnet ist.

FIG 1 und FIG 2 zeigen zudem, dass das vorstehende Stück zweiter Art 4 wenigstens im Wesentlichen an einer Außeneckecke bzw. im Bereich der Außenecke des Rahmens 2 angeordnet ist.

Eine diagonale Anordnung zueinander ist zudem denkbar.

Vorteilhaft sind wenigstens ein vorstehendes Stück erster Art 3 und das vorstehende Stück zweiter Art 4 miteinander verbunden und in gegensätzliche Richtungen ragend ausgebildet.

Vorteilhaft ist eine Ausführungsform, wonach wenigstens ein vorstehendes Stück erster Art und das Fixierungselement miteinander verbunden und in gegensätzliche Richtungen ragend ausgebildet sind. Dies kann durch einen zylindrischen Körper gelingen, der an einem Ende das vorstehende Stück erster Art 3 und am anderen Ende das vorstehende Stück zweiter Art 4 aufweist.

Das vorstehende Stück erster Art 3 ist vorteilhaft als Positionierzapfen ausgebildet.

Auf diese Weise gelingt eine genaue Positionierung der Vorrichtung 1 auf einer Oberfläche des Kühlkörpers 8. Vorteilhaft liegt hierbei keine form- und/oder kraftschlüssige Verbindung vor.

Eine Fixierung des Rahmens 2 auf dem Kühlkörper 8 gelingt z. B. mittels Klebung.

Das vorstehende Stück erster Art 3 weist vorteilhaft eine Form auf, die sich wenigstens im Wesentlichen passgenau in die Vertiefung 12 oder Öffnung des Kühlkörpers 8 einfügt.

Das vorstehende Stück erster Art 3 weist vorteilhaft einen runden Querschnitt auf. Jedoch sind auch andere Formen denkbar.

Das vorstehende Stück zweiter Art 4 ist vorteilhaft als Zentrierdom ausgebildet. Dies ermöglicht eine genaue Zentrierung der Ansteuerungseinheit. Es sind keine Führungswerkzeuge nötig.

Der Rahmen 2 ist vorteilhaft derart ausgebildet, dass eine aufgebrachte Vergussmasse innerhalb eines Bereichs, der vom Rahmen 2 und dem Leistungsmodul 10 bzw. eine Seite des Leistungsmoduls 10 eingegrenzt ist, verbleibt.

Der Rahmen 2 ist hierzu vorteilhaft mit einer Oberfläche des Leistungsmoduls 10 stoffschlüssig, insbesondere mittels Klebung, verbunden.

Als Vergussmasse eignet sich besonders gut Silikon. Auch Polyurethan und/oder Epoxide sind denkbar.

Silikon ist hochtemperaturbeständig. Zudem erstarrt Silikon bei Raumtemperatur bzw. mittels UV-Licht.

Silikon besitzt überdies sehr gute elektrisch isolierende Eigenschaften und ist niedrig viskos und weist ein gutes Fließverhalten auf.

Die Leistungseinheit 11 ist vorteilhaft mit dem Kühlkörper 8 verbunden. Diese Verbindung gelingt vorzugsweise mittels Pressen und/oder Löten und/oder Sintern. Es sind jedoch auch andersartige Verbindungen, insbesondere eine Verbindung mittels anderer thermisch leitender Materialen, denkbar.

Zudem sind auch Verbindungen möglich, welche durch einen Eintrag thermischer Energie, z. B. Schweißen, gelingen.

Die Leistungseinheit 11 ist vorteilhaft als Teil eines moduleigenen Kühlkörper ausgebildet.

Die Leistungseinheit ist vorteilhaft als Direct Copper Bonded (auch DCB genannt) ausgeführt.

Der moduleigene Kühlkörper weist vorteilhaft die Leistungseinheit 11 sowie Kontaktierungselemente auf.

Ein Kühlkörper 8 weist vorteilhaft wenigstens eine Leistungseinheit 11 auf. Ein Kühlkörper 8 kann jedoch auch zwei oder mehr Leistungseinheiten 11 umfassen.

Optimal ist, wenn ein Kühlkörper 8 drei Leistungseinheiten 11 umfasst. Dies gewährleistet eine gute Kühlung bei einer optimalen Auslastung im Hinblick auf Leistung.

Drei Leistungseinheiten 11 sind vorteilhaft, da jeweils eine Leistungseinheit einer Phase eines dreiphasigen Systems zugeordnet werden kann.

Das Halbleiterbauelement 6 ist beispielsweise ein Thyristor oder ein MOSFET oder ein IGBT. Auch andere Halbleiterbauelemente sind denkbar.

Ist das Halbleiterbauelement 6 als IGBT ausgeführt, wird zudem eine Freilaufdiode benötigt. Es sind auch andere Halbleiterbauelemente denkbar.

Die Ansteuerungseinheit 20 ist vorzugsweise ein Power Board (auch Hauptplatine genannt), also eine Leiterplatte samt Bestückung mit Bauelementen, und dient vorzugsweise einer Ansteuerung sowie einer Energieversorgung, vorzugsweise mittels Gleichspannung.

FIG 2 zeigt zudem ein Vorrichtung, die zur Auflage eines Deckels ausgebildet ist. Die Vorrichtung weist beispielsweise eine Mehrzahl an Nasen 13 auf.

Der Deckel 14 ist in FIG 3 dargestellt. Der Deckel ermöglicht mitunter eine Führung der Pins 9. Der Deckel kann hierzu Aussparungen aufweisen.

Zudem bietet der Deckel 14 Schutz bei Explosionen. Bei Leistungstests werden die Halbleiterbauelemente derart gefordert bzw. überlastet, dass es zu Explosionen kommen kann. Der Deckel dient dem Umgebungsschutz, insbesondere dem Schutz des Umrichters bzw. Stromrichters.

Der Deckel weist hierzu beispielsweise glasfaserverstärktes Polycarbonat auf.

FIG 3 und FIG 4 zeigen das Leistungsmodul 10, welches mit der Ansteuerungseinheit 20 verbunden ist.

FIG 4 zeigt eine Mehrzahl an elektronischen Bauelementen 24.

Ein elektronische Bauelement 24 ist beispielsweise ein Kondensator, ein Widerstand oder eine Diode. Es sind auch andere Bauelemente möglich. Die elektronischen Bauelemente 24 dienen vorzugsweise einer Ansteuerung.

Das vorstehende Stück zweiter Art 4 greift vorteilhaft in eine Vertiefung oder, wie in den Figuren gezeigt, eine Öffnung 20 der Ansteuerungseinheit ein.

Dies ermöglicht eine gute Zentrierung.

Die Figur zeigt zudem eine Kühlkörperabdeckung bzw. einen Halterahmen 23.

FIG 4 zeigt ein Fixierungselement 5.

Dies dient einer Fixierung der Ansteuerungseinheit 20. Das Fixierungselement ist vorteilhaft derart ausgebildet, dass die Ansteuerungseinheit gestützt wird.

Ferner weist das Fixierungselement 5 vorteilhaft einen Hohlraum auf, in welchem beispielsweise ein Gewinde ausgebildet ist. Dies bietet den Vorteil, dass mittels einer Schraube 51, die Ansteuerungseinheit 5 fixiert werden kann.

Ferner ist es möglich, dass das Fixierungselement 5 einen Hohlraum aufweist, dergestalt, dass eine gewindefurchende bzw. gewindeschneidende Schraube befestigbar ist.

Das Leistungsmodul 10 ist vorzugsweise Teil eines Umrichtersystems. Das Umrichtersystem ist vorzugsweise hoch-performant und eignet sich besonders gut für einen Antrieb von Produktions- und Werkzeugmaschinen sowie in der Glas- und/oder Verpackungsindustrie. Weitere Anwendungsgebiete sind Heating, Ventilation, Air-Conditioning, Pumpen und Standard-Lüfter sowie verschiedene Umrichteranwendungen.

Die Erfindung bietet den Vorteil, dass Prozess-, Montage- und Fertigungsschritte vereinfacht werden und Kosten, insbesondere im Hinblick auf eingesetztes Material, reduziert werden können. Für die beschriebene Vorrichtung muss wesentlich weniger Material verwendet werden als für ein bisher übliches Gehäuse.

Der Stromrichter wird dadurch auch leichter.

Anstatt eine eingehauste Leistungseinheit auf dem Kühlkörper zu verschrauben und hierzu Buchsen im Gehäuse einzusetzen, wird die beschriebene Vorrichtung vorteilhaft direkt auf dem Kühlkörper angebracht.

Zur einfacheren Positionierung und der Sicherstellung gegen Verdrehen sind vorteilhaft mindestens zwei Zapfen vorgesehen, die nur in ein zur Positionierung minimal tiefes Loch, vorzugsweise Sackloch, eintauchen. Vorzugsweise beträgt die Tiefe 1 mm bis 5 mm.

Der Kühlkörper 8 samt Leistungseinheit 11 wird vorteilhaft mittels des wenigstens einen Positionierzapfens in einer Funktion als Positionierwerkzeug in die Hauptplatine geführt und so eine Positionierung ermöglicht.

Mittels der Schraube 51 am Fixierelement wird vorteilhaft eine durchgängige mechanische Verbindung vom Kühlkörper 8 zur Hauptplatine geschaffen. Mit dieser Verbindung ist zusätzlich eine direkte Ausrichtung dieser Bauteile durch den Positionierzapfen gestaltet. Dies fördert eine bessere konstruktive Abstimmung der Bauteile.

FIG 5 zeigt einen Stromrichter 30.

Der Stromrichter 30 weist wenigstens ein Leistungsmodul 10 auf, welches bereits beschrieben wurde. Der Stromrichter kann auch eine Mehrzahl an Leistungsmodulen 10 aufweisen.

Der Stromrichter weist zudem eine wenigstens ein elektronisches Bauelement 24 aufweisende Ansteuerungseinheit 20 auf.

Das Leistungsmodul 10 und die Ansteuerungseinheit 20 sind, wie in der Figur gezeigt, miteinander verbunden.

## Patentansprüche

1. Vorrichtung (1) zur Einfassung einer wenigstens teilweise innerhalb und/oder auf einem Kühlkörper (8) ausgebildeten Leistungseinheit (11) und zur Zentrierung einer Ansteuerungseinheit (20) bezüglich der Leistungseinheit (11), wobei die Leistungseinheit (11) wenigstens ein Halbleiterbauelement (6) und ein Substrat (7) umfasst, aufweisend:
- einen Rahmen (2), wobei der Rahmen (2) das Substrat (7) wenigstens teilweise, vorzugsweise vollständig, umgibt,
- wenigstens ein vorstehendes Stück erster Art (3), wobei das vorstehende Stück erster Art (3) zum Eingriff in eine Vertiefung oder eine Öffnung (12) eines Kühlkörpers (8) ausgebildet ist,
- wenigstens ein vorstehendes Stück zweiter Art (4), wobei das vorstehende Stück zweiter Art (4) zum Eingriff in eine Vertiefung oder eine Öffnung (21) der wenigstens ein elektronisches Bauelement (24) aufweisenden Ansteuerungseinheit (20) ausgebildet ist.

2. Vorrichtung (1) nach Anspruch 1, wobei die Vorrichtung (1) zwei vorstehende Stücke erster Art (3) aufweist.

3. Vorrichtung (1) nach einem der vorhergehenden Ansprüche, wobei die Vorrichtung (1) ein Fixierungselement (5) zur Fixierung der Ansteuerungseinheit (20) aufweist.

4. Vorrichtung (1) nach einem der vorhergehenden Ansprüche, wobei der Rahmen (2) rechteckig ausgebildet ist

5. Vorrichtung (1) nach einem der vorhergehenden Ansprüche, wobei das vorstehende Stück erster Art (3) wenigstens im Wesentlichen an einer Ecke, insbesondere Außenecke, des Rahmens (2) angeordnet ist.

6. Vorrichtung (1) nach einem der vorhergehenden Ansprüche, wobei das vorstehende Stück zweiter Art (4) wenigstens im Wesentlichen an einer Ecke, insbesondere Außenecke, des Rahmens (2) angeordnet ist.

7. Vorrichtung (1) nach einem der vorhergehenden Ansprüche, wobei wenigstens ein vorstehendes Stück erster Art (3) und das vorstehende Stück zweiter Art (4) miteinander verbunden und in gegensätzliche Richtungen ragend ausgebildet sind.

8. Vorrichtung (1) nach einem der vorhergehenden Ansprüche, wobei wenigstens ein vorstehendes Stück erster Art (3) und das Fixierungselement (5) miteinander verbunden und in gegensätzliche Richtungen ragend ausgebildet sind.

9. Vorrichtung (1) nach einem der vorhergehenden Ansprüche, wobei der Rahmen (2) Polyphenylensulfid aufweist.

10. Leistungsmodul (10), aufweisend:
- wenigstens einen Kühlkörper (8),
- wenigstens eine Leistungseinheit (11), wobei die Leistungseinheit (11) wenigstens ein Halbleiterbauelement (6) und ein Substrat (7) umfasst,
- eine Vorrichtung (1) nach einem der Ansprüche 1 bis 9, wobei die Vorrichtung (1) umfasst:
- einen Rahmen (2), wobei der Rahmen (2) das Substrat (7) wenigstens teilweise, vorzugsweise vollständig, umgibt,
- wenigstens ein vorstehendes Stück erster Art (3), wobei das vorstehende Stück erster Art (3) zum Eingriff in eine Vertiefung oder eine Öffnung (12) des Kühlkörpers (8) ausgebildet ist,
- wenigstens ein vorstehendes Stück zweiter Art (4), wobei das vorstehende Stück zweiter Art (4) zum Eingriff in eine Vertiefung oder eine Öffnung (21) einer wenigstens ein elektronisches Bauelement (24) aufweisenden Ansteuerungseinheit (20) ausgebildet ist.

11. Leistungsmodul (10) nach Anspruch 10, wobei der Rahmen (2) derart ausgebildet ist, dass eine aufgebrachte Vergussmasse innerhalb eines Bereichs, der vom Rahmen (2) und dem Leistungsmodul (10) eingegrenzt ist, verbleibt.

12. Leistungsmodul (10) nach einem der Ansprüche 10 oder 11, wobei der Rahmen (2) mit einer Oberfläche des Leistungsmoduls (10) stoffschlüssig, insbesondere mittels Klebung, verbunden ist.

13. Stromrichter (30), aufweisend:
- ein Leistungsmodul (10) nach einem der Ansprüche 10 bis 12,
- eine wenigstens ein elektronisches Bauelement (24) aufweisende Ansteuerungseinheit (20),
wobei das Leistungsmodul (10) und die Ansteuerungseinheit (20) miteinander verbunden sind.

14. Stromrichter (30) nach Anspruch 13, wobei die Ansteuerungseinheit (10) bezüglich des Leistungsmoduls (10) durch einen Eingriff des vorstehenden Stücks zweiter Art (4) des Leistungsmoduls (10) in eine Vertiefung oder eine Öffnung (21) der Ansteuerungseinheit (20) zentriert ist.

15. Stromrichter (30) nach einem der Ansprüche 13 oder 14, wobei das Leistungsmodul (10) und die Ansteuerungseinheit (20) mittels des Fixierungselements (5) verbunden sind.
